# EUROPEAN PATENT APPLICATION

(11) **EP 4 819 792 A1**
(43) Date of publication of application: **07.10.2026**
(21) Application number: 25168153.2
(22) Date of filing: 03.04.2025
(51) Int. Cl.: H10D 30/60, H10D 64/00

(54) **TRANSISTOR DEVICE COMPRISING A DRAIN EXTENSION REGION**

(71) Applicant: Infineon Technologies Austria AG, 9500 Villach (AT)
(72) Inventor: ABU ZAHRA, Mohammad Khalid Mohammad, 81671 München (DE); KAUTZSCH, Thoralf, 01309 Dresden (DE); REPP, Jens, 85570 Markt Schwaben (DE); BRANDL, Matthias, 85614 Kirchseeon (DE); RUDOLF, Ralf, 01097 Dresden (DE); DIXIUS, Leon Minh, 81829 München (DE)
(74) Representative: Infineon Patent Department

(57) **Abstract**

A transistor device for high voltage and cryogenic applications. The transistor device comprises a drain extension region extending from a drain region towards a source region. The drain extension region is separated from the source region by a body region which is gated by a first gate electrode. The drain extension region increases the separation of the drain region with respect to the source region and the first gate electrode, reducing a risk of source-drain or gate-drain breakdown. A second gate electrode, different to the first gate electrode, is positioned over the drain extension region. A distance between the second gate electrode and the drain region, along a surface of the drain extension region, is no greater than 400 nm. The second gate electrode controls the conductivity of the drain extension region using an applied voltage, enabling the drain extension region to conduct at cryogenic temperatures.

## Description

### TECHNICAL FIELD

The present disclosure relates to the field of quantum computing, and in particular, to transistors for quantum circuits.

### BACKGROUND

There is growing interest and rapid development in the field of quantum computing. One particular type of quantum computing environment is a trapped ion environment, in which computing is performed using ions as qubits for computation. The excitation state of an electron of an ion indicates a logical value or logic state. Ions such as barium (Ba), magnesium (Mg), calcium (Ca), beryllium (Be), or the like, may be positively charged, and a single electron in the outer shall of the ion used as the logic element. Two or more ions may be entangled, as changing the state of one qubit causes the entangled qubits to change their state immediately, having the potential to provide substantial speed and power savings over conventional computing.

Quantum computing requires a well-controlled environment, and precise handling of the ions. Generally, ions in a trapped ion device are trapped or controlled using electromagnetic fields. For example, ions may be moved between locations (e.g., storage, processing and readout locations) in a process called ion shuttling.

In order to control the ion movement, electrodes are controlled to provide an intended electromagnetic field (EM-field). Therefore, accurate control of the EM-fields created by the electrodes in the trapped ion device is desired. For example, it would be advantageous to reduce any noise or other undesired fluctuations of voltage that is provided to the electrode, which may cause fluctuations of the EM-field experienced by the ion(s), as the location and movement of the ion(s) may be sensitive even to subtle changes in the EM-field provided by the electrode.

Additionally, state of the art trapped ion devices, and quantum computing devices in general, typically operate at cryogenic temperatures to reduce thermal noise or fluctuations that can disrupt the trapped ion states. Therefore, electrical components that can function in cryogenic environments are desired.

### SUMMARY

There is provided a transistor device comprising: a source electrode; a source region; a drain electrode; a drain region; a drain extension region extending from the drain region towards the source region, wherein the drain region and the source region are separated from one another by a body region; a first gate electrode positioned on the body region for controlling a current flow through the body region; and a second gate electrode, different to the first gate electrode, positioned on the drain extension region, wherein a distance between the second gate electrode and the drain region, along a surface of the drain extension region, is no greater than 400 nm.

Those skilled in the art will recognize additional features and advantages upon reading the following detailed description, and upon viewing the accompanying drawings.

### BRIEF DESCRIPTION OF THE DRAWINGS

The present disclosure is illustrated by way of example, and not by way of limitation, in the figures of the accompanying drawings in which like reference numerals refer to similar or identical elements. The elements of the drawings are not necessarily to scale relative to each other. The features of the various illustrated examples can be combined unless they exclude each other.
Fig. 1 illustrates a transistor device as known from the prior art;
Fig. 2 illustrates a proposed transistor device;
Fig. 3 illustrates another proposed transistor device;
Fig. 4 illustrates yet another proposed transistor device;
Fig. 5 illustrates yet another proposed transistor device;
Fig. 6 illustrates a proposed transistor arrangement;
Fig. 7 illustrates a proposed transistor system;
Fig. 8 illustrates operating states of the proposed transistor system;
Fig. 9 illustrates a portion of a proposed particle trapping device; and
Fig. 10 illustrates I-V characteristics for a proposed transistor device.

### DETAILED DESCRIPTION

The examples described herein provide a transistor device for high voltage and cryogenic applications. The transistor device comprises a drain extension region extending from a drain region towards a source region. The drain extension region is separated from the source region by a body region which is gated by a first gate electrode. The drain extension region increases the separation of the drain region with respect to the source region and the first gate electrode, reducing a risk of source-drain or gate-drain breakdown. A second gate electrode, different to the first gate electrode, is positioned over the drain extension region. A distance between the second gate electrode and the drain region, along a surface of the drain extension region, is no greater than 400 nm. The second gate electrode controls the conductivity of the drain extension region using an applied voltage, enabling the drain extension region to conduct at cryogenic temperatures.

Reference may be made herein to the spatial relationships between various components and to the spatial orientation of various aspects of components as the devices are depicted in the attached drawings. However, as will be recognized by those skilled in the art after a complete reading of the present disclosure, the devices, members, apparatuses, etc. described herein may be positioned in any desired orientation. Thus, the use of terms such as "above," "below," "upper," "lower," or other like terms to describe a spatial relationship between various components or to describe the spatial orientation of aspects of such components should be understood to describe a relative relationship between the components or a spatial orientation of aspects of such components, respectively, as the device described herein may be oriented in any desired direction.

Throughout this disclosure, ordinal numbers (e.g. "first", "second" and so on) have been used purely to distinguish different elements from one another for the sake of clarity, and reference to a non-"first" (e.g. "second" or "third") element does not necessitate that a "first" element be present. The skilled person would be capable of relabeling any such elements as appropriate (e.g. relabeling a "second" element as a "first" element if only the second element is present).

The present disclosure generally relates to the field of particle trapping systems or devices, such as trapped ion devices, for quantum computing. In a particle trapping device, there is commonly a desire to control the location of a particle (e.g., an ion) that is being held within a containment region. This may be to facilitate movement of the ion between different locations, each designated for the performance of different quantum computing tasks (e.g., storage, processing and/or readout). In other examples, the particle trapping system may be used in metrology (e.g., as part of an atomic clock).

Moving a particle in a containment region of a particle trapping device typically requires manipulating an electric field that surrounds the particle. Appropriate manipulation of the electric field surrounding the particle can therefore be used to control the location of the particle. There is therefore a need to facilitate precise and accurate control of the electric field surrounding a particle.

A typical particle trapping device will control the electric field applied to a particle in a containment region through controlling a voltage provided to each of a plurality of electrodes surrounding or bounding the containment region. By accurately controlling the voltage provided to each electrode, the electric field surrounding the ion can be manipulated or controlled, thereby facilitating precise control over the position of the ion (with respect to the plurality of electrodes).

To control the voltage provided to each electrode, the particle trapping device typically comprises a switching matrix (i.e., a plurality of switches) to control coupling of each electrode to one or more signal lines. Each switch of the switching matrix controls whether or not a voltage is provided to a corresponding electrode (via the one or more signal lines) and also allows for isolation of the electrode (e.g., after a voltage is provided) to reduce electrical noise at the electrode. Transistors (in particular, MOSFETs) are commonly used as switches due to their fast-switching capabilities and low power requirements.

Typically, with current state of the art technology for particle trapping devices, the voltage required for each electrode is relatively high (>10V), in order to facilitate accurate control within the containment region. To function properly, each switch of the switching matrix desirably needs to withstand this high voltage and not experience electrical breakdown.

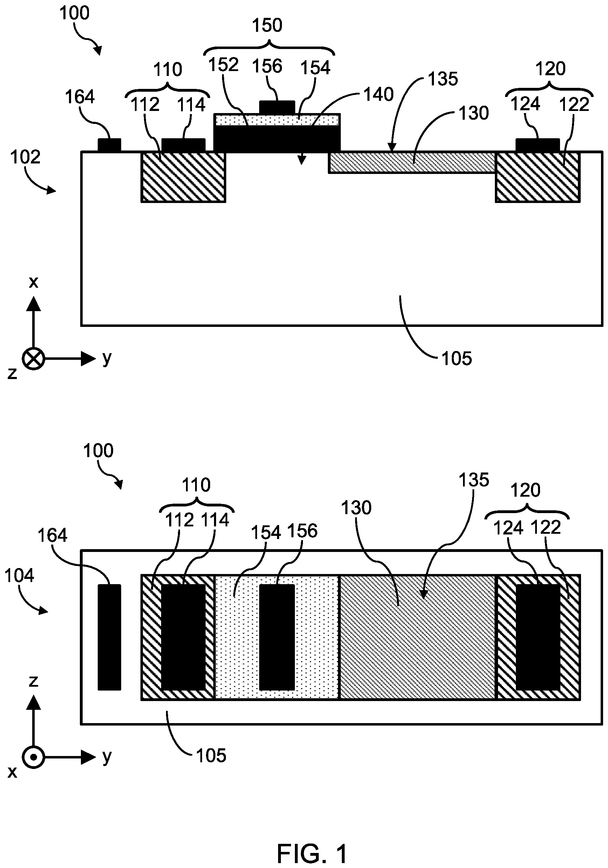

Fig. 1 provides an example of an existing transistor device 100 configured for high-voltage applications (e.g., between 9 V to 120 V). Specifically, Fig. 1 illustrates a side view 102 (e.g., a cross-section) and a top view 104 of the transistor device 100.

The transistor device 100 may comprise a metal-oxide-semiconductor field-effect-transistor (MOSFET). For instance, the transistor device 100 may comprise an n-MOSFET (i.e., an n-type or n-channel MOSFET) or a p-MOSFET (i.e., a p-type or p-channel MOSFET) dependent on a type of doping (e.g., n-doping or p-doping) present in each component of the transistor device 100.

In some embodiments, the transistor device 100 comprises an enhancement-type transistor device (e.g., an enhancement MOSFET). It will be appreciated that the present disclosure is equally applicable to a depletion-type transistor device (e.g., a depletion MOSFET) and the skilled person would be readily capable of modifying aspects of the present disclosure to suit such a device.

The transistor device 100 comprises a body region 105 on/in which a remainder of the transistor device 100 is fabricated and/or arranged. The body region 105 (or a portion thereof) may function as a substrate of the transistor device 100. In some embodiments, the body region 105 is arranged on/in a (further) substrate comprising a different (or differently doped) material to the body region. Additionally, one or more epitaxial layers may be formed at the boundary between the body region and the substrate.

The body region 105 typically comprises a doped semiconductor material, such as (doped) Si. In some embodiments, the type of doping (e.g., n-type, or p-type) present in the body region 105 may be dependent on (or define) a doping type of the transistor device 100. For instance, for an n-type transistor device 100, the body region 105 (typically) comprises a p-doped semiconductor (e.g., p-doped Si). Additionally, for a p-type transistor device 100, the body region 105 (typically) comprises an n-doped semiconductor (e.g., n-doped Si). The type of doping present in the body region 105 is therefore typically opposite to the type of doping for the transistor device 100 as a whole.

The transistor device 100 further comprises a source region 112 and a source electrode 114 which together form a source 110 of the transistor device 100. The source region 112 is embedded into the body region 105 and comprises a doped semiconductor material, typically (doped) Si. The type of doping present in the source region 112 is opposite to that (if present) in the body region 105. For example, for an n-type transistor device 100 (having a p-doped body region 105), the source region 112 comprises an n-doped semiconductor (and vice versa for a p-type transistor device).

The (absolute) doping concentration of the source region 112 is typically much higher than that of the body region 105. In particular, the source region 112 is typically doped into a heavily doped regime, e.g., n+ or p+ doping. In such regimes, the conductivity of the source region 112 is greatly increased (compared to lighter or zero doping regimes). For example, the doping concentration present in the source region 112 is no less than 1 × 10¹⁹ cm⁻³.

In some examples, the source region 112 is formed through doping a portion of the body region 105, e.g., with a doping opposite to a remainder of the body region 105 (the doped portion thus forming the source region 112).

The source electrode 114 is arranged on a surface of the source region 112, e.g., on top of the source region 112. The source electrode 114 comprises a conductive material, such as a metal or polysilicon, for example, and forms an electrical contact to the source region 112. When connected to electrical signal lines of an electrical circuit (e.g., via a metallization structure), the source electrode 114 facilitates transfer of a received electrical signal (e.g., an electrical current, an electrical voltage) from the source electrode 114 to the source region 112 (and vice versa).

The transistor device 100 further comprises a drain region 122 and a drain electrode 124 which together form a drain 120 of the transistor device 100. The drain region 122 is embedded into the body region 105 and comprises a doped semiconductor material, typically (doped) Si. The type of doping present in the drain region 122 is opposite to that (if present) of the body region 105. For example, for an n-type transistor device 100 (having a p-doped body region 105), the drain region 122 comprises an n-doped semiconductor (and vice versa for a p-type transistor device).

The drain region 122 typically comprises a same or similar (e.g., same order of magnitude) doping concentration to that of the source region 112. For example, the doping concentration present in the drain region 122 is no less than 1 × 10¹⁹ cm⁻³.

In some examples, the drain region 122 is formed through doping a portion of the body region 105, e.g., with a doping opposite to a remainder of the body region 105 (the doped portion thus forming the drain region 122).

The drain electrode 124 is arranged on a surface of the drain region 122, e.g., on top of the drain region 122. The drain electrode 124 comprises a conductive material, such as a metal or polysilicon, for example, and forms an electrical contact to the drain region 122. When connected to electrical signal lines of an electrical circuit (e.g., via a metallization structure), the drain electrode 124 facilitates transfer of a received electrical signal (e.g., an electrical current, an electrical voltage) from the drain electrode 124 to the drain region 122 (and vice versa).

In some examples, the source 110 and drain 120 comprise a same (or similar) composition and arrangement. Accordingly, the labels "source" and "drain" for the source 110 and drain 120 may be interchangeable. In other words, the source may be equivalently considered as the drain, and vice versa.

The source region 112 and the drain region 122 are separated from each other by the body region 105. Furthermore, in some examples, due to the opposite doping of each of the source region 112 and the drain region 122 with respect to the body region 105, a depletion region forms at the boundary of each of the source region 112 and the drain region 122 with respect to the body region 105. Thus, in the absence of any (sufficiently high) electric field or applied voltage, the source region 112 and the drain region 122 are electrically isolated from each other.

The transistor device 100 further comprises a drain extension region 130 extending from the drain region 122 towards the source region 112. The drain extension region 130 is embedded in the body region 105 and contacts the drain region 122.

The drain extension region 130 comprises a doped semiconductor material, typically the same material as the drain region 122. The drain extension region 130 also comprises a same type of doping as the drain region 122, at a lower concentration in some embodiments. In particular, the drain extension region 130 is typically doped only into a lightly doped regime, e.g., n- or p-doping. Thus, the drain extension region 130 is typically conductive (at certain temperatures), but to a lower degree than the drain region 122. In some embodiments, the doping concentration present in the drain extension region 130 is between 1 × 10¹⁶ cm⁻³ to 1 × 10¹⁹ cm⁻³, such as between 1 × 10¹⁷ cm⁻³ to 1 × 10¹⁸ cm⁻³.

For use in later disclosure, the drain extension region 130 comprises a (top) surface 135.

The drain extension region 130 is separated from the source region 112 by the body region 105. The body region 105 may comprise a channel region 140 in which a current channel may form, e.g., depending on a voltage applied to a gate 150 of the transistor device 100.

The transistor device 100 further comprises a first gate electrode 154 positioned on (e.g., above/over) the channel region 140 (or more generally on the body region 105). In this context, it will be appreciated that "on" does not mean "directly on" (i.e., in contact with). Rather, something may be "on" something else when separated by a further element. Thus, the first gate electrode 154 may be considered to be on the body region 105 even when separated by one or more intervening layers. Conversely, something described as being "on a surface" of something else should be understood as being in contact with said surface.

The first gate electrode 154 is separated from the channel region 140 by a first gate insulating layer 152. Specifically, the first gate electrode 154 is arranged on a top surface of the first gate insulating layer 152, a bottom surface (opposite the top surface) of the first gate insulating layer 152 being in contact with the channel region 140. Typically, the first gate electrode 154 fully covers the top surface of the first gate insulating layer 152.

The first gate insulating layer 152 is configured to electrically isolate the first gate electrode 154 from the channel region 140. To this end, the first gate insulating layer 152 comprises an insulating material, typically an oxide such as SiO₂. The first gate insulating layer 152 thus acts as a dielectric between the first gate electrode 154 and the channel region 140.

The first gate electrode 154 comprises a conductive material. In some examples, the first gate electrode 154 comprises a metal, e.g., Pt, Au, Al, Ag, etc., or combinations thereof. In other examples, the first gate electrode 154 comprises polycrystalline Si (poly-Si). In such examples, a first gate contact 156 (typically a metal contact) may be formed on top of the first gate electrode 154. This may improve electrical contact to the first gate electrode 154, in some examples.

Together, the first gate insulating layer 152, the first gate electrode 154, and (when present) the first gate contact 156 form a first gate 150.

The first gate 150 is configured to control the conductivity of (and thus current flow through) the channel region 140. Specifically, a voltage applied to the first gate electrode 154 (e.g., via a signal line connected to the first gate contact 156) produces an electric field across the channel region 140. This modifies the distribution of charge carriers in the channel region 140 (or at least a portion of the channel region 140 closest to the first gate insulating layer 152) affecting the conductivity of the channel region 140. For a sufficiently high voltage (of a certain sign), an inversion layer or depletion layer forms in the channel region 140, thereby increasing the conductivity of the channel region 140 and allowing current flow therethrough. Accordingly, due to the inherent conductivity of the source region 112, the drain region 122, and the drain extension region 130, when a sufficiently high voltage is applied to the first gate electrode 154, current is able to flow from the source 110 to the drain 120 (and vice versa) via the drain extension region 130 and the channel region 140.

The first gate 150 thus acts like a switch where current is permitted to flow (i.e., switch closed) or current is prevented from flowing (i.e., switch open) dependent on the voltage of the first gate electrode 154 (or more precisely a gate-source voltage between the first gate electrode 154 and the source 110) as is well established in the art. When used in this way, the first gate 150 may be referred to as a switching gate.

To be specific, for an n-type transistor device 100 (and thus a p-doped body region 105), current is only permitted to flow through the channel region 140 for a positive gate-source voltage above a given threshold. Conversely, for a p-type transistor device 100 (and thus an n-doped body region 105), current is only permitted to flow through the channel region 140 for a negative gate-source voltage below a given threshold.

For use in later disclosure, the act of applying a voltage to a gate electrode to create an electric field over a target region is commonly referred to as gating (the target region also being referred to as the gated region). Additionally, when a voltage applied to a gate electrode (of a gate) is sufficient to permit current flow through a gated region, the gate is said to be "ON" or in an ON-state. Conversely, when the voltage applied a gate electrode is not sufficient to permit current flow through a gated region, the gate is said to be "OFF" or in an OFF-state. Together, the ON-state and OFF-state (or any similar state) are referred to as switching states. Furthermore, switching of a gate refers to changing the switching state of the gate, e.g., switching the gate from ON to OFF or vice versa.

It will be appreciated that, when the first gate 150 is ON, current may not be able to flow through the entirety of the channel region 140. Rather, current may only be able to flow through a portion of the channel region 140, specifically the inversion/depletion layer that forms at the boundary of the channel region 140 with the first gate insulating layer 152. Thus, in some embodiments, dependent on the magnitude of the voltage applied to the first gate electrode 154, the inversion/depletion layer may only form in a portion of the channel region 140.

Consider from an alternative perspective, the channel region 140 may be defined as the inversion/depletion layer, i.e., the portion of the body region 105 through which current may flow depending on a voltage being applied to the first gate 150. Thus, the size of the channel region 140 may change dependent on the voltage applied to the first gate electrode 154. Accordingly, when the first gate 150 is OFF, the channel region 140 may not exist, as the voltage applied to the first gate electrode 154 is not sufficient to form an inversion layer.

In some embodiments, the first gate electrode 154 is positioned on (e.g., over) the whole of the channel region 140. Additionally, at least a portion of the first gate electrode 154 may be positioned on the source region 112 and/or the drain extension region 130. This may allow the first gate 150 to gate a greater proportion of the channel region 140 (e.g., the whole of the channel region 140) such that a continuous conductive channel may be formed between the source region 112 and the drain extension region 130.

The transistor device 100 may further comprise a body electrode 164 for grounding the body region 105. The body electrode 164 typically comprises a metal contact and connects the body region 105 to a ground. In some examples, the body electrode 164 and the source electrode 114 share a common electrical connection.

The drain extension region 130 enables the transistor device 100 to be used for high-voltage switching applications, e.g., capable of operating at source-drain voltages in the range 9 V to 120 V. Specifically, for a high voltage applied to the drain 120 with respect to the source 110 and the first gate electrode 154, a large proportion of the voltage drops across the drain extension region 130. This reduces a risk of a source-drain or a (first) gate-drain breakdown, i.e., current flowing from the source 110 or the first gate electrode 154 to the drain 120 when the first gate 150 is OFF. Thus, the transistor device 100 is capable of functioning as a switch even at high source-drain voltages.

The voltage drop across the drain extension region 130 is increased at lower doping concentrations due to a greater drain extension region 130 resistance. This further reduces the risk of an electrical breakdown.

Accordingly, the transistor device 100 may be used as a switch for high-voltage switching in a particle trapping device, e.g., capable of decoupling a high-voltage electrode from one or more signal lines.

The present disclosure recognizes that the conductivity of the drain extension region 130 is temperature dependent. In particular, at cryogenic temperatures (such as below 70 K), the conductivity of the drain extension region 130 drops significantly due to freeze out of the charge carriers added from doping. This effect is made worse when the drain extension region 130 is only lightly doped. As a result, the resistance between source 110 and drain 120 is greatly increased (at cryogenic temperatures), even when the first gate 150 is ON.

As a consequence, a small source-drain voltage is required to permit current flow through the drain extension region 130 at cryogenic temperatures. The I-V behavior of the transistor device 100 is also non-linear in this regime. Together, these effects reduce the switching efficiency of the transistor device 100 at cryogenic temperatures, which is undesirable in particle trapping devices where accurate and reliable voltage control and/or electrode switching is vital.

The present disclosure provides a modified transistor device capable of high-voltage switching at cryogenic temperatures.

In particular, it has been herein recognized that field-effect conductivity modulation, as employed by the first gate 150 to control current flow through the channel region 140, may also be used to enhance the conductivity of the drain extension region 130 at low temperatures. Specifically, an applied electric field may be used to ionize, excite, or otherwise mobilize charge carriers within at least part of the drain extension region 130, allowing current to flow through the drain extension region 130 even at low temperatures.

It is herein proposed to integrate a second gate electrode into the transistor device, different to the first gate electrode, positioned on (e.g., over) the drain extension region. Particularly, a distance between the drain electrode and a projection of the second gate electrode onto the drain extension region, along a surface of the drain extension region, is no greater than 400 nm. This minimizes an area of the drain extension region close to the drain region that does not have a portion of the second gate electrode positioned on it, resulting in more uniform gating of the drain extension region close to the drain region.

The present disclosure further recognizes that switching of a gate of a transistor device between an ON and OFF state may cause a charge injection effect. In particular, while a voltage is applied to the gate electrode, the gate effectively acts like a capacitor with a stored charge. Switching the gate OFF releases (at least some of) this stored charge, which is provided to the source and drain, i.e., they experience charge injection. When a transistor device such as this is used in a particle trapping device, the charge injection caused by switching the gate may disrupt the voltage at a connected electrode, potentially resulting in disturbance or even loss of a trapped particle.

It has been found that certain configurations and ways of operating the second gate electrode help to minimize this charge injection effect. Thus, in some embodiments, it is proposed to configure the second gate electrode to reduce charge injection caused by switching the first and/or second gate electrodes.

Different embodiments and/or arrangements of a proposed transistor device comprising a second gate electrode will now be described.

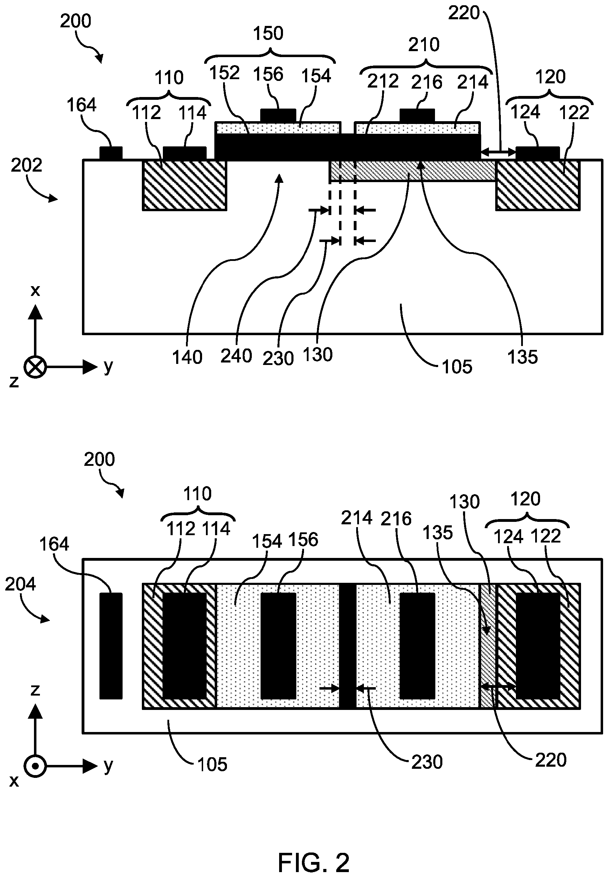

Fig. 2 illustrates a side view 202 and a top view 204 of a proposed transistor device 200. The transistor device 200 comprises all of the elements of the transistor device 100 of Fig. 1. The transistor device 200 further comprises a second gate 210.

The second gate 210 comprises a second gate electrode 214 positioned on (e.g., above/over) the drain extension region 130. The second gate electrode 214 comprises a conductive material, e.g., a metal, poly-Si, etc. This may be the same material as that of the first gate electrode 154.

In the present example, the second gate electrode 214 is positioned entirely above the drain extension region 130. In other words, a projection of the second gate electrode 214 onto the surface 135 of the drain extension region 130 (i.e., projected along the x-axis) is entirely encompassed within a boundary of the surface 135. Thus, the second gate electrode 214 may only gate the drain extension region 130.

The second gate 210 further comprises a second gate insulating layer 212 that separates (and electrically isolates) the second gate electrode 214 from the drain extension region 130. Specifically, the second gate electrode 214 is arranged on a top surface of the second gate insulating layer 212, a bottom surface (opposite the top surface) of the second gate insulating layer 212 being in contact with the surface 135 of the drain extension region 130.

In the present example, the second gate insulating layer 212 is part of a same insulating layer as the first gate insulating layer 152. In other words, the first gate 150 and the second gate 210 share a same insulating layer. Thus, the second gate insulating layer 212 and the first gate insulating layer 152 have a same composition, e.g., comprising an oxide.

The second gate 210 may further comprise a second gate contact 216 arranged on a surface of the second gate electrode 214. In particular, the second gate contact 216 may be used in examples where the second gate electrode 214 does not comprise a metal, thus providing a metallic contact to the second gate electrode 214.

The second gate electrode 214 acts to modulate the conductivity of the drain extension region 130 through an applied electric field. More specifically, a voltage applied to the second gate electrode 214 (e.g., via the second gate contact 216) creates an electric field across the drain extension region 130. This ionizes (i.e., mobilizes) charge carries in the drain extension region 130 (dependent on the strength and direction of the electric field), increasing the conductivity of the drain extension region 130 and (for a sufficiently high voltage) allowing current to flow through the drain extension region 130 if it couldn't before.

To be more precise, the voltage applied to the second gate electrode 214 may only ionize charge carriers in a portion of the drain extension region 130. Particularly, similar to the formation of the inversion/depletion layer in the channel region 140, charge carriers may only be ionized in a layer of the drain extension region 130 formed at the boundary with the second gate insulating layer 212. The size/thickness of this ionization/depletion layer may be dependent on the magnitude of the voltage applied to the second gate electrode 214, e.g., thicker for a greater voltage. Thus, at low temperatures, current flow through the drain extension region 130 may only occur through a portion of the drain extension region 130.

In particular, for cryogenic temperatures below 70 K (e.g., below 50 K), a positive voltage above a given threshold may be required to ionize (majority) charge carriers (e.g., electrons) in an n-doped drain extension 130, whereas a negative voltage below a given threshold may be required to ionize charge carriers (e.g., holes) in a p-doped drain extension 130. Furthermore, each threshold is temperature dependent, being greater in magnitude for lower temperatures. Thus, a greater voltage is typically required to ionize charge carriers within the drain extension region 130 at lower temperatures.

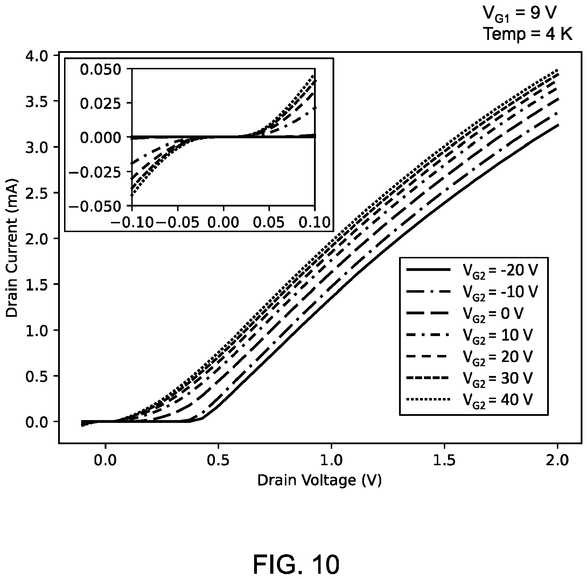

It will be appreciated that application of a negative voltage for an n-doped drain extension 130, or a positive voltage for a p-doped drain extension 130, may still cause ionization of (minority) charge carriers in the drain extension region 130. However, this will result in an inversion layer (within the drain extension region 130) with majority carriers opposite that in the drain region 122, thus resulting in a depletion region forming between the inversion layer and the drain region 122 that blocks current flow. This effect is evidenced in Fig. 10 which illustrates, in an n-type transistor device, drain current as a function of (source-) drain voltage at different second gate voltages (and constant first gate voltage and temperature). At more positive second gate voltages, the drain current is greater and starts to increase at a lower drain voltage. However, at more negative second gate voltage, the drain current is smaller and only starts to increase at a higher drain voltage. Thus, the conductivity of the drain extension region is improved at more positive second gate voltages and worsened at more negative second gate voltages.

Accordingly, current flow through the drain extension region 130 may be controlled through controlling the voltage applied to the second gate electrode 214, e.g., permitted when the voltage breaches a temperature-dependent threshold, or restricted when the voltage fails to breach a temperature-dependent threshold.

Any voltage applied to the second gate electrode 214 is typically distinct from (i.e., different to, or separate from) any voltage applied to the first gate electrode 154. In other words, voltages applied to the second gate electrode 214 and the first gate electrode 154, respectively, are separately controlled.

It will be appreciated that, when no voltage is applied to the second gate electrode 214, current may still be permitted to flow through the drain extension region 130 (when the first gate 150 is ON) for a sufficiently high source-drain voltage. The voltage applied to the second gate electrode 214 thus acts to reduce the source-drain voltage at which current flow through the drain extension region 130 is permitted (as demonstrated in Fig. 10). This source-drain voltage can be minimized to provide efficient transistor device switching. Integration of the second gate electrode 214 into the transistor device 200 therefore enables improved switching functionalities at cryogenic temperatures (compared to the transistor device 100 of Fig. 1).

It is further recognized that, at cryogenic temperatures and low source-drain voltages, the second gate 210 may be used as a switching gate of the transistor device 200. In particular, for a given temperature and/or source-drain voltage, a voltage threshold exists for the second gate electrode 214, corresponding to a voltage of the second gate electrode 214 that produces a sufficiently strong electric field to ionize charge carriers in the drain extension region 130. When the voltage applied to the second gate electrode 214 breaches this voltage threshold (i.e., goes above the threshold for an n-doped drain extension region 130, or goes below the threshold for a p-doped drain extension region 130) current is able to flow through the drain extension region 130. However, when the voltage applied to the second gate electrode 214 fails to breach this voltage threshold, current is prevented from flowing through the drain extension region 130, regardless of the switching state of the first gate 150.

The second gate 210 may therefore be used as a switching gate in addition to (or instead of) the first gate 150. Particularly, dependent on the temperature and source-drain voltage, current may only be permitted to flow between the source 110 and the drain 120 when both the first gate 150 and the second gate 210 are ON. Conversely, current flow may be prevented when any one of the first gate 150 and the second gate 210 are OFF.

The physical dimensions of the second gate 210 may be configured to reduce charge injection effects resulting from switching of the second gate 210. In particular, the amount of charge released/injected by the second gate 210 on changing the voltage of the second gate electrode 214 is proportional to the capacitance of the second gate 210. Additionally, the capacitance of the second gate 210 is proportional to the ratio between the area of the second gate electrode 214 (in contact with the second gate insulating layer 212) and the thickness of the second gate insulating layer 212. Thus, the degree of charge injection caused by switching the second gate 210 may be reduced by decreasing the area of the second gate electrode 214 and increasing the thickness of the second gate insulating layer 212. This concept will be expanded on further in the later disclosure.

A (lateral) distance 220 separates the second gate electrode 214 (or a projection thereof onto the surface 135 of the drain extension region 130) from the drain electrode 124 when measured along the surface 135 of the drain extension region 130, i.e., in or perpendicular to the y-z plane. As previously disclosed, the distance 220 is no greater than 400 nm. For instance, the distance 220 may be (approximately) no greater than 300 nm, 200 nm, 100 nm, etc., or as close to 0 nm as is possible with current manufacturing techniques (i.e., within an acceptable error or tolerance). Reducing the lateral distance between the second gate electrode 214 and the drain electrode 124 provides more complete and uniform gating of the drain extension region 130 close to the drain region 122. This improves the conductance between the drain region 122 and the drain extension region 130 when the second gate 210 is ON.

Additionally, a (lateral) distance 230 separates the second gate electrode 214 from the first gate electrode 154. In some embodiments, the second gate electrode 214 and the first gate electrode 154 are not in contact with each other (such as electrically isolated from each other). This reduces a risk of a voltage applied to one gate electrode being provided to the other gate electrode, thus allowing separate control of the two gate electrodes.

According to embodiments, the distance 230 (or more generally the distance between projections of the second gate electrode 214 and the first gate electrode 154 onto the surface 135, when measured along the surface 135 of the drain extension region 130) is no greater than 400 nm. For instance, the distance 230 may be (approximately) no greater than 400 nm, 300 nm, 200 nm, 100 nm, etc., or as close to 0 nm as is possible with current manufacturing techniques (i.e., within an acceptable error or tolerance). When considered together with the distance 220, this minimizes the area of the drain extension region 130 that does not have a portion of a gate electrode (i.e., the first or second gate electrode) positioned on it. This results in a more uniform and complete gating of the drain extension region 130, reducing a risk of a portion of the drain extension region 130 not being sufficiently gateable/ionizable (compared to other portions of the drain extension region 130) and thus restricting current flow.

A distance 240 separates the second gate electrode 214 (or a projection thereof onto the surface 135 of the drain extension region 130) from the channel region 140 when measured along the surface 135 of the drain extension region 130. According to embodiments, the distance 240 is no greater than 400 nm. For instance, the distance 240 may be (approximately) no greater than 400 nm, 300 nm, 200 nm, 100 nm, etc., or as close to 0 nm as is possible with current manufacturing techniques (i.e., within an acceptable error or tolerance). This results in a greater proportion of the drain extension region 130 having the second gate electrode 214 positioned on it as opposed to the first gate electrode 154. Accordingly, the conductivity of the drain extension region 130 is predominantly controlled by the second gate electrode 214 rather than the first gate electrode 154.

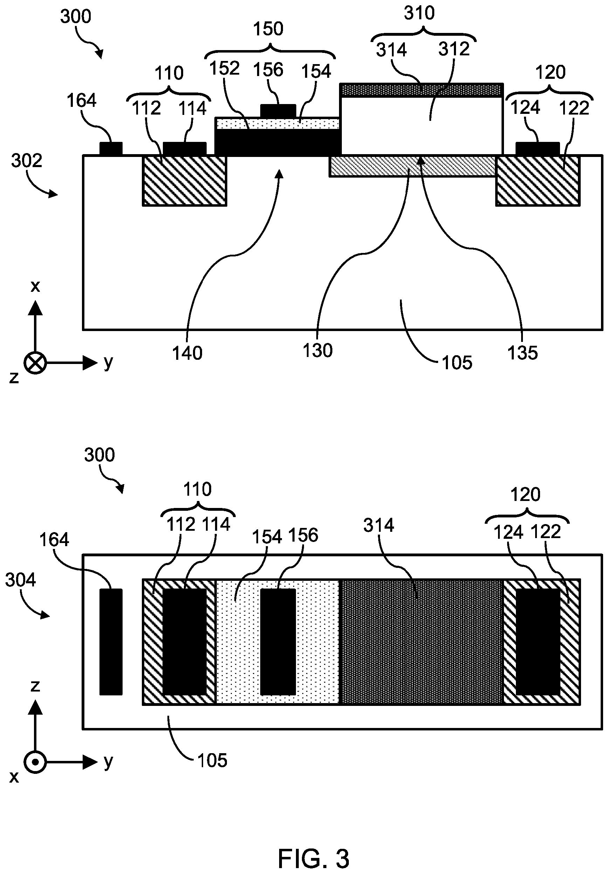

Fig. 3 illustrates a side view 302 and a top view 304 of another proposed transistor device 300. The transistor device 300 comprises all of the elements of the transistor device 100 of Fig. 1. The transistor device 300 further comprises a second gate 310.

The second gate 310 comprises a second gate electrode 314 positioned on (e.g., above/over) the drain extension region 130. In this example, the second gate electrode 314 comprises a metal plate different in composition to the first gate electrode 154. When the second gate electrode 314 comprises a metal, a strong (direct) electrical connection may be formed between the second gate electrode 314 and an electrical signal line of an electrical circuit (e.g., via a metallization structure).

Additionally, a portion of the second gate electrode is positioned on the drain region 122. This advantageously provides more complete and uniform gating of the part of the drain extension region 130 closest to the drain region 122.

The second gate 310 further comprises a second gate insulating layer 312 that separates the second gate electrode 314 from the drain extension region 130. Specifically, the second gate electrode 314 is arranged on a top surface of the second gate insulating layer 312, a bottom surface (opposite the top surface) of the second gate insulating layer 312 being in contact with the surface 135 of the drain extension region 130.

In this example, the second gate insulating layer 312 forms a separate insulating layer compared to the first gate insulating layer 152. Furthermore, the second gate insulating layer 312 is thicker than the first gate insulating layer 152, i.e., forms a greater separation between the second gate electrode 314 and the drain extension region 130 compared to the separation between the first gate electrode 154 and the channel region 140. This enables a greater voltage to be applied to the second gate electrode 314 (compared to the first gate electrode 154) without causing dielectric breakdown of the insulating layer.

Additionally, increasing the thickness of the second gate insulating layer 312 may reduce the charge injection caused by switching the second gate 310.

In some embodiments, the second gate insulating layer 312 is formed from a same material as the first gate insulating layer 152.

In some embodiments, the second gate insulating layer 312 is partially embedded/buried in the drain extension region 130 and/or the body region 105. In other words, the components of the transistor device need not lie in or on a same plane.

It will be appreciated that the second gate 310 may typically operate/function in the same way as the second gate 210 of Fig. 2.

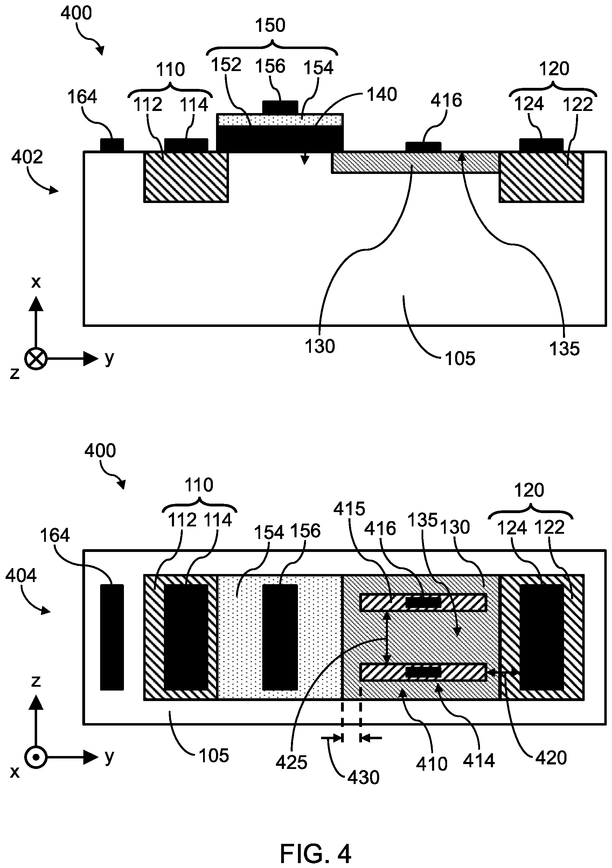

Fig. 4 illustrates a side view 402 and a top view 404 of a transistor device 400. The transistor device 400 comprises all of the elements of the transistor device 100 of Fig. 1. The transistor device 400 further comprises a second gate 410.

In this example, the second gate 410 comprises a second gate electrode 414 positioned on the drain extension region 130. More specifically, the second gate electrode 414 comprises a plurality of second gate electrode segments 415 each embedded into the surface 135 of the drain extension region 130 and positioned between the first gate electrode 154 and the drain electrode 124. The second gate 410 also comprises a plurality of second gate contacts 416 each arranged on a surface of a respective second gate electrode segment 415.

Each second gate electrode segment 415 comprises a doped semiconductor material, e.g., (doped) Si. In particular, the type of doping present in each second gate electrode segment 415 is opposite to that of the drain extension region 130. For example, each second gate electrode segment 415 is p-doped when the drain extension region 130 is n-doped (and vice versa). This creates a depletion region at the boundary between each second gate electrode segment 415 and the drain extension region 130 which, in turn, produces an internal electric field inside the drain extension region 130. At certain temperatures (e.g., above a certain threshold) this electric field may be sufficient to ionize charge carries within the drain extension region 130, increasing its conductivity.

Additionally, a voltage may be applied to each second gate electrode segment 415 (e.g., via a respective second gate contact 416) in reverse bias (i.e., negative voltage for p-doped electrode segments, or positive voltage for n-doped electrode segments, with respect to drain) to produce a further electric field inside the drain extension region 130. The magnitude of each voltage (and thus strength of the further electric field) may be controlled to achieve ionization of charge carriers within the drain extension region 130 at lower temperatures.

A (lateral) distance 420 separates each second gate electrode segment 415 (or a projection thereof onto the surface 135 of the drain extension region 130) from the drain electrode 124 when measured along the surface 135 of the drain extension region 130, i.e., in the y-z plane. This distance is equivalent to the distance 220 of Fig. 2. Accordingly, the distance 420 is no greater than 400 nm. For instance, the distance 420 may be (approximately) no greater than 400 nm, 300 nm, 200 nm, 100 nm, etc., or as close to 0 nm as is possible with current manufacturing techniques (i.e., within an acceptable error or tolerance).

In the present example, each second gate electrode segment 415 takes the form of a stripe directed along the y-axis (i.e., the direction pointing from the channel region 140 towards the drain region 122). Additionally, the plurality of second gate electrode segments 415 are arranged/spaced along the z-axis. When arranged this way, different voltages may be applied to adjacent second gate electrode segments to create a transverse (to the direction of current flow between source 110 and drain 120) electric field between them comparable to a plate capacitor. This provides further ionization of charge carriers within the drain extension region 130.

In some examples, a distance 425 between adjacent second gate electrode segments (or projections thereof onto the surface 135 of the drain extension region 130) is no greater than 400 nm. For instance, the distance 425 may be (approximately) no greater than 400 nm, 300 nm, 200 nm, 100 nm, etc., or as close to 0 nm as is possible with current manufacturing techniques (i.e., within an acceptable error or tolerance).

A distance 430 separates each second gate electrode segment 415 from the first gate electrode 154 (or projections thereof onto the surface 135 of the drain extension region 130). According to embodiments, each second gate electrode segment 415 and the first gate electrode 154 are not in contact with each other (such as electrically isolated from each other). This reduces a risk of a voltage applied to one gate electrode being provided to the other gate electrode, thus allowing separate control of the two gate electrodes.

According to embodiments, the distance 430 is no greater than 400 nm. For instance, the distance 430 may be (approximately) no greater than 400 nm, 300 nm, 200 nm, 100 nm, etc., or as close to 0 nm as is possible with current manufacturing techniques (i.e., within an acceptable error or tolerance).

Thus, when considered together with the distance 420, each second gate electrode segment 415 spans the majority of (e.g., all of) the distance (along the surface 135 of the drain extension region 130) between the first gate 150 and the drain region 122. This results in a more complete gating/ionization of the drain extension region 130.

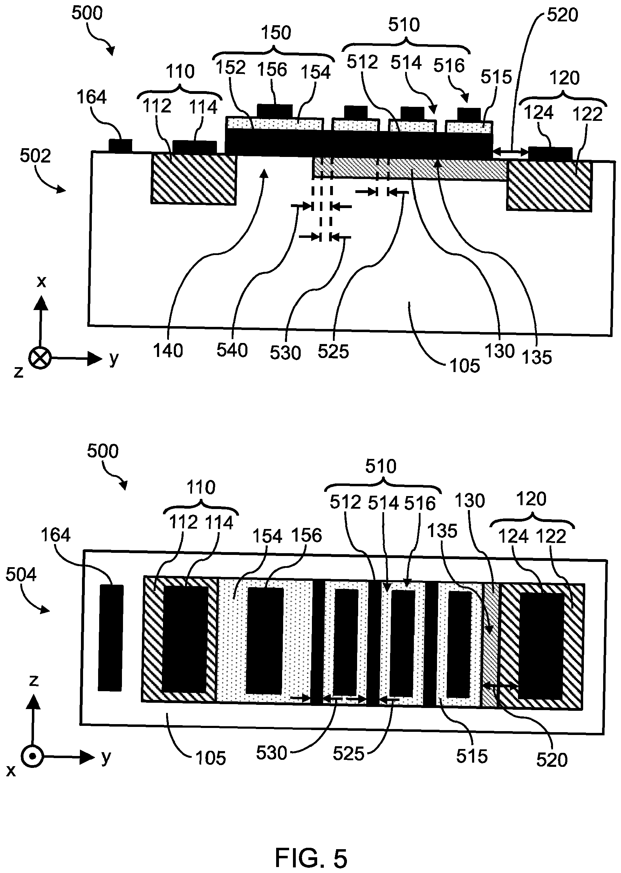

Fig. 5 illustrates a side view 502 and a top view 504 of a transistor device 500. The transistor device 400 comprises all of the elements of the transistor device 100 of Fig. 1. The transistor device 400 further comprises a second gate 510.

In this example, the second gate 510 comprises a second gate electrode 514 positioned on the drain extension region 130. More specifically, the second gate electrode 514 comprises a plurality of second gate electrode segments 515 each positioned on (e.g., above/over) the drain extension region 130 and positioned between the first gate electrode 154 and the drain electrode 124. Each second gate electrode segment 515 comprises a conductive material, e.g., a metal, poly-Si, etc. This may be the same material as that of the first gate electrode 154.

The second gate 510 further comprises a second gate insulating layer 512 that separates each second gate electrode segment 515 from the drain extension region 130. Specifically, each second gate electrode segment 515 is arranged on a top surface of the second gate insulating layer 512, a bottom surface (opposite the top surface) of the second gate insulating layer 512 being in (direct) contact with the surface 135 of the drain extension region 130.

In the present example, the second gate insulating layer 512 is part of a same insulating layer as the first gate insulating layer 152. In other words, the first gate 150 and the second gate 510 share a same insulating layer. Thus, the second gate insulating layer 512 and the first gate insulating layer 152 have a same composition, e.g., comprising an oxide. In other examples, the first gate 150 and the second gate 510 may comprise different/distinct insulating layers. For example, the second gate 510 may comprise a thicker insulating layer, e.g., similar to the second insulating layer 312 of Fig. 3, and/or an insulating layer of a different material, compared to the insulating layer of the first gate 150.

The second gate 510 may also comprise a plurality of second gate contacts 516 each arranged on a surface of a respective second gate electrode segment 515.

The second gate 510 therefore (primarily) differs from the second gate 210 of Fig. 2 in that the second gate electrode is separated into a plurality of segments. In particular, the plurality of second gate electrode segments 515 are arranged in a line spanning from the first gate electrode 154 to the drain electrode 124. Additionally, in some embodiments each second gate electrode segment 515 is not in contact with any other second gate electrode segment 515. Each second gate electrode segment 515 thus acts as a distinct/separate gate electrode of the second gate 510, allowing for gating/ionization of individual portions of the drain extension region 130. In other words, the voltage applied to each second gate electrode segment 515 may be controlled separately.

Separation of the second gate electrode 514 into a sequence of second gate electrode segments may reduce the charge injection caused by switching the second gate 510. More specifically, each second gate electrode segment 515 comprises a smaller area than the second gate electrode 514 as a whole. Thus, switching of any single one of the second gate electrode segments 515 results in less charge injection that switching the entirety of the second gate electrode 514.

Furthermore, switching of the second gate 510 may be achieved through switching only some (i.e., not all) of the second gate electrode segments 515. In other words, current flow through the drain extension region 130 as a whole may be controlled through controlling the conductivity of only a portion of the drain extension region 130. This results in less charge injection (compared to using all of the second gate electrode segments for switching) due to reducing the effective area of the second gate electrode 514. In other words, as a smaller proportion of the second gate electrode 514 is used for switching, a smaller amount of charge is injected by switching the second gate 510 between ON and OFF.

To facilitate this, a remainder of the drain extension region 130, can be conductive at all times. Specifically, during operation of the transistor device 500, a voltage may be continually applied to at least one, but not all, of the plurality of second gate electrode segments, e.g., all but one of the second gate electrode segments, half of the second gate electrode segments, only one of the second gate electrode segments, etc. The conductivity of the portions of the drain extension region 130 on which said second gate electrode segments are positioned may therefore be high enough to always permit current flow. Accordingly, the remainder of the plurality of second gate electrode segments (i.e., those that don't have a voltage continually applied to them) may be used for switching the second gate 510 through controlling a voltage applied to them.

A distance 520 separates the second gate electrode 514 (or a projection thereof onto the surface 135 of the drain extension region 130) from the drain electrode 124 when measured along the surface 135 of the drain extension region 130, i.e., in the y-z plane. More specifically, distance 520 corresponds to the distance between the drain electrode 124 and the second gate electrode segment closest to the drain electrode 124 (or a projection thereof onto the surface 135 of the drain extension region 130). This distance is equivalent to the distances 220, 420 of Figs. 2 and 4. Accordingly, the distance 520 is no greater than 400 nm. For instance, the distance 520 may be (approximately) no greater than 400 nm, 300 nm, 200 nm, 100 nm, etc., or as close to 0 nm as is possible with current manufacturing techniques (i.e., within an acceptable error or tolerance).

According to embodiments, a distance 525 between adjacent second gate electrode segments (or projections thereof onto the surface 135 of the drain extension region 130) is no greater than 400 nm. For instance, the distance 525 may be (approximately) no greater than 400 nm, 300 nm, 200 nm, 100 nm, etc., or as close to 0 nm as is possible with current manufacturing techniques (i.e., within an acceptable error or tolerance). This results in a more complete gating/ionization of the drain extension region 130.

Additionally, a distance 530 separates the second gate electrode 514 from the first gate electrode 154 (or projections thereof onto the surface 135 of the drain extension region 130). More specifically, distance 530 corresponds to the distance between the first gate electrode 154 and the second gate electrode segment closest to the first gate electrode 154. According to embodiments, the distance 530 is no greater than 400 nm. For instance, the distance 530 may be (approximately) no greater than 400 nm, 300 nm, 200 nm, 100 nm, etc., or as close to 0 nm as is possible with current manufacturing techniques (i.e., within an acceptable error or tolerance). Thus, when considered together with the distance 520, the plurality of second gate electrode segments 415 spans the majority of (e.g., all of) the distance (along the surface 135 of the drain extension region 130) between the first gate electrode 154 and the drain region 122. This results in a more complete gating/ionization of the drain extension region 130.

The following embodiments relate to applications or uses of the proposed transistor devices.

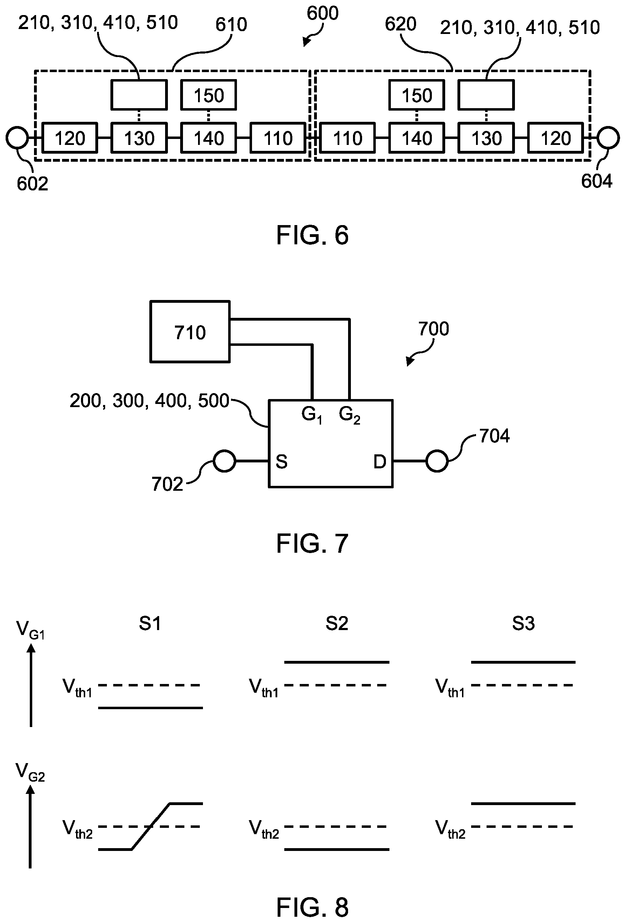

Fig. 6 illustrates a transistor arrangement 600 comprising a first transistor device 610 and a second transistor device 620 different to the first transistor device 610. Each of the first and second transistor devices comprise any herein proposed transistor device . In particular, each of the first and second transistor devices may comprise a transistor device comprising all the elements of the transistor device 100 of Fig. 1 and additionally the second gate 210, 310, 410, 510 of any of Figs. 2 to 5.

In this example, the source 110 of the first transistor device 610 is connected to the source 110 of the second transistor device 620 (or more specifically, the source electrodes of each transistor device are connected to each other). Additionally, the drain 120 (or more specifically the drain electrode) of the first transistor device 610 is connected to an input 602 and the drain 120 (or more specifically the drain electrode) of the second transistor device 620 is connected to an output 604.

The transistor arrangement 600 provides an arrangement for the first transistor device 610 and the second transistor device 620 to be operated as a switch between the input 602 and the output 604. In particular, the transistor arrangement 600 allows for a reduced charge injection experienced at the output 604 when switching the transistor arrangement between an ON state (where current is permitted to flow between the input 602 and the output 604) and an OFF state (where current is restricted/prevented from flowing between the input 602 and the output 604).

To be more specific, in this arrangement, only the first transistor device 610 is operated as a switch (i.e., switched between being open or closed) while the gates of the second transistor device 620 remain ON. In other words, were the second transistor device 620 to be considered as a switch, it would stay closed (i.e., in an ON state). The second transistor device 620 instead acts as a charge injection absorber due to the capacitive nature of the first and second gates of the second transistor device 620, thus limiting the amount of charge reaching the output 604 when one of the gates of the first transistor device 610 is switched OFF.

In some examples, the transistor arrangement 600 comprises one or more capacitors each connected between a source 110 or drain 120 of either the first transistor device 610 or the second transistor device 620 and ground (or some other reference voltage). This further reduces the charge injection experienced by the output 604.

In some examples, only the second gate 210, 310, 410, 510 of the first transistor device 610 is operated as a switch, i.e., the first gate 150 of the first transistor device 610 is kept ON. This may be the case when the second gate 210, 310, 410, 510 (of the first transistor device 610) is configured to produce less charge injection than the first gate 150. It will be appreciated that this approach may only be used when the source-drain voltage of the first transistor device 610 is sufficiently low.

Alternatively, only the second gate 210, 310, 410, 510 of the second transistor device 620 may be operated as a switch. This may be performed in a similar manner to that previously described for the first gate.

The skilled person will appreciate that the approach provided by the present embodiment could be equally enabled through connecting the drains of each transistor device together rather than the sources of each transistor device (and instead connecting the sources of each transistor device to an input and an output, respectively).

Fig. 7 illustrates a transistor system 700 comprising any herein proposed transistor device 200, 300, 400, 500, e.g., as described with reference to any of Figs. 2 to 5. The transistor device 200, 300, 400, 500 comprises a source S (i.e., source 110), a drain D (i.e., drain 120), a first gate G₁ (i.e., first gate 150) and a second gate G₂ (i.e., second gate 210, 310, 410, 510). The source S is connected to an input 702 and a drain D is connected to an output 704. In other examples, the input 702 and the output 704 may be reversed, i.e.., connected to the drain D and the source S, respectively.

The transistor system 700 further comprises a gate control system configured to control the first gate G₁ and the second gate G₂ (or more precisely gate electrodes thereof). Specifically, the gate control system 710 is configured to control whether the first gate G₁ and the second gate G₂ are ON or OFF, i.e., whether or not one or more voltages provided to gate electrodes of each of the first gate G₁ and the second gate G₂ are sufficient to breach a respective voltage threshold for permitting current flow. Thus, the gate control system 710 is configured to control current flow between the source S and the drain D through controlling the first gate G₁ and the second gate G₂.

Reference herein will be made to the first gate G₁ and the second gate G₂. However, any reference to control of, or a voltage provided to, the first gate G₁ or the second gate G₂ will be understood to mean control of, or a voltage provided to, a gate electrode of the first gate G₁ or the second gate G₂, respectively.

At a minimum, the gate control system 710 may be configured to control whether one or more voltages are provided to each of the first gate G₁ and the second gate G₂, each voltage breaching a respective threshold. In other words, the gate control system 710 may not control the magnitude/value of each of the one or more voltages, but simply whether said voltages are received by the first gate G₁ and/or the second gate G₂. Thus, the gate control system 710 may control whether the first gate G₁ and the second gate G₂ are ON or OFF via controlling whether or not each gate receives one or more (breaching) voltages.

In other examples, the gate control system 710 may (also) be configured to control the value of the one or more voltages provided to the first gate G₁ and the second gate G₂. Thus, the gate control system 710 may control whether the first gate G₁ and the second gate G₂ are ON or OFF by controlling the value of the one or more voltages provided to each gate and whether or not they breach a respective threshold. To facilitate this, the gate control system 710 may control a voltage supply connected to the first gate G₁ and the second gate G₂. In some examples, the gate control system 710 comprises said voltage supply.

In some examples, the gate control system 710 comprises a digital-to-analog converter (DAC) for converting a digital input signal to an analog output signal. In particular, the gate control system 710 may be configured to take in a binary signal (e.g., as provided/generated by a user) indicative of a switching state of the first gate G₁ and/or the second gate G₂. Accordingly, the gate control system 710 may convert said binary signal into one or more output voltages for switching the first gate G₁ and/or the second gate G₂ to a desired switching state.

The gate control system 710 may be operable in different states corresponding to different switching states (or control thereof) of the first gate G₁ and the second gate G₂ and an accompanying current flow (or lack thereof). In particular, each state of the gate control system 710 may control a coupling between the input 702 and the output 704, e.g., whether, and under what conditions, current is permitted to flow between the input 702 and the output 704 via the source S and the drain D.

The gate control system 710 may only be operable in some states when a voltage between the source S (or a source region thereof) and the drain D (or a drain region thereof) is below a predetermined temperature-dependent threshold, thereby allowing the second gate G₂ to function as a switching gate. Additionally, the gate control system 710 may only be operable in some states when the transistor device 200, 300, 400, 500 (or elements thereof) is/are at a temperature below a predetermined temperature. Specifically, the predetermined temperature may correspond to a cryogenic temperature, e.g., no greater than 70 K, e.g., no greater than 50 K.

Fig. 8 illustrates three different operating states of the gate control system 710. Specifically, voltages applied to the first gate G₁ and the second gate G₂, and their relation to a respective voltage threshold Vₜₕ₁, Vₜₕ₂, are illustrated for each operating state. In this context, each voltage threshold Vₜₕ₁, Vₜₕ₂ corresponds to a threshold for which, upon breaching, the first gate G₁ and the second gate G₂, respectively, are switched to an ON state.

The present example is applicable for an n-type transistor device. The skilled person will be readily capable of modifying the described voltages to achieve the different states for the gate control system 710 for a p-type transistor device.

In a first state S1, the voltage applied to the first gate G₁ is below the respective voltage threshold Vₜₕ₁ and, thus, the first gate G₁ is OFF. Accordingly, in the first state S1, current is prevented from flowing through a body region of the transistor device 200, 300, 400, 500. In other words, while in the first state S1, the gate control system 710 is configured to control the first gate G₁ to prevent current flow through the body region.

The first state S1 thus corresponds to a state in which current is prevented from flowing between the input 702 and the output 704 regardless of a source-drain voltage of the transistor device 200, 300, 400, 500. In other words, in the first state S1, the input 702 and the output 704 are (completely) decoupled from each other. It will be appreciated that this decoupling is independent of the switching state of the second gate G₂. Thus, in the first state S1, the voltage applied to the second gate G₂ may be above or below the respective voltage threshold Vₜₕ₂.

In a second state S2, the voltage applied to the first gate G₁ is above the respective voltage threshold Vₜₕ₁ and, thus, the first gate G₁ is ON. Accordingly, in the first state S1, current is permitted to flow through the body region of the transistor device 200, 300, 400, 500. Meanwhile, the voltage applied to the second gate G₂ is below the respective voltage threshold Vₜₕ₂ and, thus, the second gate G₂ is OFF. Accordingly, in the second state S2, current is prevented from flowing through a drain extension region of the transistor device 200, 300, 400, 500 for certain conditions.

While in the second state S2, the gate control system is therefore configured to control the first gate G₁ to permit current flow through the body region and control the second gate G₂ to prevent current flow (under certain conditions) through the drain extension region. The second state S2 thus corresponds to a state in which current may be prevented from flowing between the input 702 and the output 704 under certain conditions. Specifically, current is only prevented from flowing when the temperature and source-drain voltage are each below corresponding (predetermined) thresholds which allow for freeze-out of charge carriers in the drain extension region. The input 702 and the output 704 may thus be described as being softly decoupled from each other, i.e., decoupled only under certain conditions.

Soft decoupling of the output 704 from the input 702 prior to (complete) decoupling may reduce an amount of charge injection experienced by the output 704. In particular, in examples where the second gate G₂ has a lower capacitance than the first gate G₁, switching the second gate G₂ to an OFF-state (corresponding to soft decoupling) results in less charge injection than switching the first gate G₁ to an OFF-state. Subsequently, i.e., after switching the second gate to an OFF-state, the first gate G₁ may be switched to an OFF-state. Due to the second gate G₂ being OFF, current flow is restricted through the drain extension region of the transistor device 200, 300, 400, 500. Accordingly, any charge released from switching the first gate G₁ may predominantly be provided to the input 702 as opposed to the output 704. This order of operations thus reduces the total charge injection at the output 704, providing more stable switching, e.g., in particle trapping systems.

In a third state S3, the voltage applied to the first gate G₁ is above the respective voltage threshold Vₜₕ₁ and, thus, the first gate G₁ is ON. Accordingly, in the third state S3, current is permitted to flow through the body region of the transistor device 200, 300, 400, 500. The voltage applied to the second gate G₂ is also above the respective voltage threshold Vₜₕ₂ and, thus, the second gate G₂ is ON. Accordingly, in the second state S2, current is permitted to flow through the drain extension region of the transistor device 200, 300, 400, 500 (independent on temperature).

The third state S3 thus corresponds to a state in which current is permitted to flow between the input 702 and the output 704 regardless of a source-drain voltage and/or a temperature of the transistor device 200, 300, 400, 500. In other words, in the first state S1, the input 702 and the output 704 are coupled to each other.

The skilled person will be readily capable of envisaging other operating states for the gate control system 710 based on the present disclosure.

It will be appreciated that the transistor device 200, 300, 400, 500 may equivalently be replaced by the transistor arrangement 600 of Fig. 6 (or some other transistor arrangement comprising a plurality of transistor devices). In such embodiments, the gate control system 710 may control each gate of the transistor arrangement. Alternatively, the gate control system 710 may control each gate of only a single transistor device of the transistor arrangement, and one or more further gate control systems may respectively control each gate of any other transistor device of the transistor arrangement.

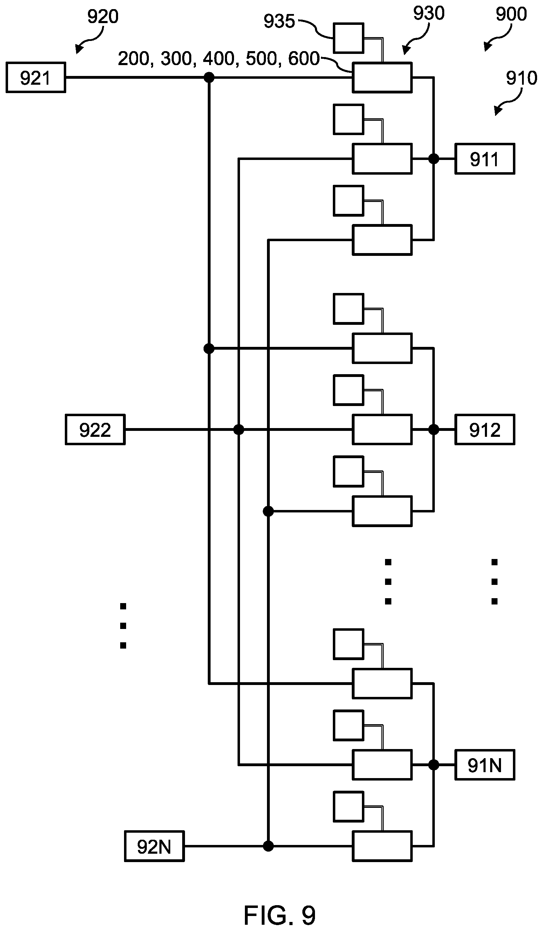

Fig. 9 illustrates a portion of a particle trapping device 900 for trapping one or more particles, e.g., ions. The particle trapping device 900 comprises a plurality of electrodes 910 (i.e., electrodes 911, 912, ...,91N) for positioning the one or more particles with respect to the particle trapping device (or more precisely with respect to the plurality of electrodes 910). Specifically, the plurality of electrodes 910 are controllable using one or more applied voltages which, when applied to the plurality of electrodes 910, generate an electromagnetic field for positioning (e.g., containing, shuttling, maneuvering) the one or more particles.

The particle trapping device 900 further comprises one or more signal lines 920 (i.e., signal lines 921, 922, ..., 92N) for carrying the one or more applied voltages. In the present example, each signal line 921, 922, ..., 92N is connected to each electrode 911, 912, ...,91N. Thus, each 911, 912, ...,91N may receive an applied voltage (or a combination thereof) from any of the signal lines 921, 922, ..., 92N. In other examples, each signal line may only be connected to some of the plurality of electrodes, e.g., only one of the plurality of electrodes.

Each signal line 921, 922, ..., 92N may be provided by a DAC that provides or defines a voltage for provision to one or more electrodes of the particle trapping device 900. Each DAC may provide an adjustable voltage on its signal line.

The particle trapping device 900 further comprises a plurality of transistor systems 930, e.g., according to the transistor system 700 of Fig. 7. In particular, the particle trapping device 900 comprises as many transistor systems 930 as there are connections between a signal line and an electrode, each connection having an associated transistor system 930. Each transistor system 930 comprises a gate control system 935 and a transistor device 200, 300, 400, 500 (e.g., according to Figs. 2 to 5) or a transistor arrangement 600 (e.g., according to Fig. 6) whose gates are controlled by the gate control system 935.

The transistor device/arrangement 200, 300, 400, 500, 600 of each transistor system 930 is connected between a respective signal line and electrode pairing (i.e., a respective pair formed between a single signal line and a single electrode). Specifically, the signal line (for a transistor system 930) is connected to the source (or drain) of the transistor device/arrangement 200, 300, 400, 500, 600 and the electrode (for the transistor system 930) is connected to the drain (or source) of the transistor device 200, 300, 400, 500. Accordingly, the transistor device/arrangement 200, 300, 400, 500, 600 for each signal line and electrode pairing may control a current flow between the signal line to the electrode, and thus control provision of an applied voltage from the signal line to the electrode.

The gate control system 935 of each transistor system 930 may be operated to control provision of an applied voltage. In particular, each gate control system 935 may be operated to couple, decouple, or softly decouple a respective signal line and electrode pairing through controlling permissible current flow through a corresponding transistor device/arrangement 200, 300, 400, 500, 600 (e.g., according to the operating states of Fig. 8). Accordingly, a voltage carried by a signal line may be prevented from being applied to a particular electrode through (softly) decoupling the electrode from the signal line.

(Soft) decoupling of an electrode may also be used to reduce charge injection experienced by the electrode (e.g., through switching of the first or second gates of a transistor device connected to the electrode) and reduce electrical noise (e.g., carried by the one or more signal lines 920) at the electrode.

In the present example, each transistor system 930 is depicted as comprising a different/distinct gate control system 935 for control of a single transistor device/arrangement 200, 300, 400, 500, 600. In other examples, the gate control system 935 of each transistor system 930 may be a same gate control system. In other words, each transistor system 930 may share the same gate control system. Said gate control system may thus control permissible current flow through each transistor device/arrangement 200, 300, 400, 500, 600 of the particle trapping system 900.

In addition to the above described examples, the following examples are disclosed.

Example 1. A transistor device comprising:
a source electrode;
a source region;
a drain electrode;
a drain region;
a drain extension region extending from the drain region towards the source region, wherein the drain region and the source region are separated from one another by a body region;
a first gate electrode positioned on the body region for controlling a current flow through the body region; and
a second gate electrode, different to the first gate electrode, positioned on the drain extension region, wherein a distance between the drain electrode and a projection of the second gate electrode onto the drain extension region, along a surface of the drain extension region, is no greater than 400 nm.

Example 2. The transistor device of example 1, wherein:
a distance between a projection of the second gate electrode onto the drain extension region and a projection of the first gate electrode onto the drain extension region, along a surface of the drain extension region, is no greater than 400 nm; and/or
a distance between a projection of the second gate electrode onto the drain extension region and the body region, along a surface of the drain extension region, is no greater than 400 nm.

Example 3. The transistor device of examples 1 or 2, wherein a doping of the drain extension region is:
a same type of doping as the drain region; and
less heavily doped than the drain region.

Example 4. The transistor device of any one of examples 1 to 3, wherein a type of doping of the source region, the drain region and the drain extension region is the same.

Example 5. The transistor device of any one of example 1 to 4, wherein the channel region comprises doped material, wherein the doped material of the channel region is of a different type of doping to the doping of the source region, the drain region and the drain extension region.

Example 6. The transistor device of any one of examples 1 to 5, wherein at least a portion of the second gate electrode is positioned on the drain region.

Example 7. The transistor device of any one of examples 1 to 6, further comprising a second gate insulating layer that separates the second gate electrode from the drain extension region.

Example 8. The transistor device of example 7, further comprising a first gate insulating layer that separates the first gate electrode from the body region.

Example 9. The transistor device of example, 8, wherein the first gate insulating layer and the second gate insulating layer form a same insulating layer.

Example 10. The transistor device of any one of examples 1 to 9, wherein the second gate electrode comprises a plurality of second gate electrode segments positioned between the first gate electrode and the drain electrode.

Example 11. The transistor device of example 10, wherein the plurality of second gate electrode segments are arranged in a line spanning from the first gate electrode to the drain electrode.

Example 12. The transistor device of example 10 or 11, wherein, during operation of the transistor device, a bias voltage is continually applied to at least one, but not all, of the plurality of second gate electrode segments.

Example 13. The transistor device of any one of examples 10 to 12, wherein, for each second gate electrode segment, a projection of said second gate electrode segment onto the surface of the drain extension region is no more than 400 nm away from a projection of at least one other second gate electrode segment onto the surface of the drain extension region.

Example 14. The transistor of device of any one of examples 1 to 13, wherein the transistor device is configured to operate in a cryogenic environment.

Example 15. A transistor arrangement comprising:
a first transistor device according to any one of examples 1 to 14; and
a second transistor device, different to the first transistor, according to any one of examples 1 to 14,
wherein the source electrode of the first transistor device is connected to the source electrode of the second transistor device.

Example 16. A transistor system comprising:
the transistor device of any one of examples 1 to 14; and
a gate control system configured to control the first gate electrode and the second gate electrode.

Example 17. The transistor system of example 16, wherein, when a voltage between the source region and the drain region of the transistor device is below a predetermined temperature-dependent threshold, the gate control system is operable in at least three states, including:
a first state in which the first gate electrode is controlled to prevent current flow through the body region; a second state in which:
   the first gate electrode is controlled to permit current flow through the body region; and
   the second gate electrode is controlled to prevent current flow through the drain extension region at temperatures below a predetermined temperature, wherein the predetermined temperature is no greater than 70K; and
   a third state in which:
   the first gate electrode is controlled to permit current flow through the body region; and
   the second gate electrode is controlled to permit current flow through the drain extension region at temperatures below the predetermined temperature.

Example 18. A particle trapping device for trapping one or more particles comprising:
a plurality of electrodes controllable, using one or more applied voltages, for positioning the one or more particles with respect to the particle trapping device; and
one or more signal lines for carrying the one or more applied voltages; and for each electrode of the plurality of electrodes, at least one transistor system of example 16 or 17, wherein the transistor of each transistor system is connected between said electrode and a respective signal line of the one or more signal lines.

Example 19. The particle trapping device of example 18, wherein the gate control system of each transistor system is a same gate control system.

Although specific examples have been illustrated and described herein, it will be appreciated by those of ordinary skill in the art that a variety of alternate and/or equivalent implementations may be substituted for the specific examples shown and described without departing from the scope of the present invention. This application is intended to cover any adaptations or variations of the specific examples discussed herein. Therefore, it is intended that this invention be limited only by the claims and the equivalents thereof.

It should be noted that the transistor devices including its embodiments as outlined in the present document may be used stand-alone or in combination with the other transistor devices disclosed in this document. Furthermore, all aspects of the transistor devices outlined in the present document may be arbitrarily combined. In particular, the features of the claims may be combined with one another in an arbitrary manner.

It should be noted that the description and drawings merely illustrate the principles of the proposed methods and systems. Those skilled in the art will be able to implement various arrangements that, although not explicitly described or shown herein, embody the principles of the invention and are included within its spirit and scope. Furthermore, all examples and embodiments outlined in the present document are principally intended expressly to be only for explanatory purposes to help the reader in understanding the principles of the proposed methods and systems. Furthermore, all statements herein providing principles, aspects, and embodiments of the invention, as well as specific examples thereof, are intended to encompass equivalents thereof.

## Claims

1. A transistor device comprising:
a source electrode;
a source region;
a drain electrode;
a drain region;
a drain extension region extending from the drain region towards the source region, wherein the drain region and the source region are separated from one another by a body region;
a first gate electrode positioned on the body region for controlling a current flow through the body region; and
a second gate electrode, different to the first gate electrode, positioned on the drain extension region, wherein a distance between the drain electrode and a projection of the second gate electrode onto the drain extension region, along a surface of the drain extension region, is no greater than 400 nm.

2. The transistor device of claim 1, wherein:
a distance between a projection of the second gate electrode onto the drain extension region and a projection of the first gate electrode onto the drain extension region, along a surface of the drain extension region, is no greater than 400 nm; and/or
a distance between a projection of the second gate electrode onto the drain extension region and the body region, along a surface of the drain extension region, is no greater than 400 nm.

3. The transistor device of claim 1 or 2, wherein a doping of the drain extension region is:
a same type of doping as the drain region; and
less heavily doped than the drain region.

4. The transistor device of any one of claims 1 to 3, wherein at least a portion of the second gate electrode is positioned on the drain region.

5. The transistor device of any one of claims 1 to 4, further comprising a second gate insulating layer that separates the second gate electrode from the drain extension region.

6. The transistor device of any one of claims 1 to 5, wherein the second gate electrode comprises a plurality of second gate electrode segments positioned between the first gate electrode and the drain electrode.

7. The transistor device of claim 6, wherein the plurality of second gate electrode segments are arranged in a line spanning from the first gate electrode to the drain electrode.

8. The transistor device of claim 6 or 7, wherein, during operation of the transistor device, a bias voltage is continually applied to at least one, but not all, of the plurality of second gate electrode segments.

9. The transistor device of any one of claims 6 to 8, wherein, for each second gate electrode segment, a projection of said second gate electrode segment onto the surface of the drain extension region is no more than 400 nm away from a projection of at least one other second gate electrode segment onto the surface of the drain extension region.

10. The transistor of device of any one of claims 1 to 9, wherein the transistor device is configured to operate in a cryogenic environment.

11. A transistor arrangement comprising:
a first transistor device according to any one of claims 1 to 10; and
a second transistor device, different to the first transistor, according to any one of claims 1 to 10,
wherein the source electrode of the first transistor device is connected to the source electrode of the second transistor device.

12. A transistor system comprising:
the transistor device of any one of claims 1 to 10; and
a gate control system configured to control the first gate electrode and the second gate electrode.

13. The transistor system of claim 12, wherein, when a voltage between the source region and the drain region of the transistor device is below a predetermined temperature-dependent threshold, the gate control system is operable in at least three states, including:
a first state in which the first gate electrode is controlled to prevent current flow through the body region;
a second state in which:
the first gate electrode is controlled to permit current flow through the body region; and
the second gate electrode is controlled to prevent current flow through the drain extension region at temperatures below a predetermined temperature, wherein the predetermined temperature is no greater than 70K; and
a third state in which:
the first gate electrode is controlled to permit current flow through the body region; and
the second gate electrode is controlled to permit current flow through the drain extension region at temperatures below the predetermined temperature.

14. A particle trapping device for trapping one or more particles comprising:
a plurality of electrodes controllable, using one or more applied voltages, for positioning the one or more particles with respect to the particle trapping device; and
one or more signal lines for carrying the one or more applied voltages; and
for each electrode, at least one transistor system of claim 12 or 13, wherein the transistor of each transistor system is connected between said electrode and a respective signal line of the one or more signal lines.

15. The particle trapping device of claim 14, wherein the gate control system of each transistor system is a same gate control system.

## Amended claims

### Amended claims in accordance with Rule 137(2) EPC.

1. A transistor system (700) comprising:
a transistor device (200, 300, 400, 500, 610, 620) comprising:
a source electrode (114);
a source region (112);
a drain electrode (124);
a drain region (122);
a drain extension region (130) extending from the drain region towards the source region, wherein the drain region and the source region are separated from one another by a body region;
a first gate electrode (154) positioned on the body region for controlling a current flow through the body region; and
a second gate electrode (214, 314, 414, 514), different to the first gate electrode, positioned on the drain extension region, wherein a distance (220, 420, 520) between the drain electrode and a projection of the second gate electrode onto the drain extension region, along a surface of the drain extension region, is no greater than 400 nm; and
a gate control system (710) configured to control the first gate electrode and the second gate electrode, wherein, when a voltage between the source region and the drain region of the transistor device is below a predetermined temperature-dependent threshold, the gate control system is operable in at least three states, including:
a first state (S1) in which the first gate electrode is controlled to prevent current flow through the body region;
a second state (S2) in which:
the first gate electrode is controlled to permit current flow through the body region; and
the second gate electrode is controlled to prevent current flow through the drain extension region only at temperatures below a predetermined temperature, wherein the predetermined temperature is no greater than 70K and only when the voltage between the source region and the drain region of the transistor device is below the predetermined temperature-dependent threshold; and
a third state (S3) in which:
the first gate electrode is controlled to permit current flow through the body region; and
the second gate electrode is controlled to permit current flow through the drain extension region at temperatures below the predetermined temperature.

2. The transistor system of claim 1, wherein:
a distance between a projection of the second gate electrode onto the drain extension region and a projection of the first gate electrode onto the drain extension region, along a surface of the drain extension region, is no greater than 400 nm; and/or
a distance between a projection of the second gate electrode onto the drain extension region and the body region, along a surface of the drain extension region, is no greater than 400 nm.

3. The transistor system of claim 1 or 2, wherein a doping of the drain extension region is:
a same type of doping as the drain region; and
less heavily doped than the drain region.

4. The transistor system of any one of claims 1 to 3, wherein a type of doping of the source region, the drain region and the drain extension region is the same.

5. The transistor system of any one of example 1 to 4, wherein the channel region comprises doped material, wherein the doped material of the channel region is of a different type of doping to the doping of the source region, the drain region and the drain extension region.

6. The transistor system of any one of claims 1 to 5, wherein at least a portion of the second gate electrode is positioned on the drain region.

7. The transistor system of any one of claims 1 to 6, further comprising a second gate insulating layer that separates the second gate electrode from the drain extension region.

8. The transistor system of claim 7, further comprising a first gate insulating layer that separates the first gate electrode from the body region.

9. The transistor system of claim 8, wherein the first gate insulating layer and the second gate insulating layer form a same insulating layer.

10. The transistor system of any one of claims 1 to 9, wherein the second gate electrode comprises a plurality of second gate electrode segments positioned between the first gate electrode and the drain electrode.

11. The transistor system of claim 10, wherein the plurality of second gate electrode segments are arranged in a line spanning from the first gate electrode to the drain electrode.

12. The transistor system of any one of claims 10 or 11, wherein, for each second gate electrode segment, a projection of said second gate electrode segment onto the surface of the drain extension region is no more than 400 nm away from a projection of at least one other second gate electrode segment onto the surface of the drain extension region.

13. A particle trapping device (900) for trapping one or more particles comprising:
a plurality of electrodes (910, 911, 912, 91N) controllable, using one or more applied voltages, for positioning the one or more particles with respect to the particle trapping device; and
one or more signal lines (920, 921, 922, 92N) for carrying the one or more applied voltages; and
for each electrode, at least one transistor system (700) of any one of claims 1 to 12, wherein the transistor of each transistor system is connected between said electrode and a respective signal line of the one or more signal lines.

14. The particle trapping device of claim 13, wherein the gate control system of each transistor system is a same gate control system.
